# EUROPÄISCHE PATENTSCHRIFT

(11) **EP 3 063 871 B1**
(45) Veröffentlichungstag und Bekanntmachung des Hinweises auf die Patenterteilung: **03.07.2019**
(21) Anmeldenummer: 14786670.1
(22) Anmeldetag: 21.10.2014
(51) Int. Cl.: H03K 17/082, H02M 1/32

(54) **ÜBERSPANNUNGSSCHUTZSCHALTUNG FÜR EINEN LEISTUNGSHALBLEITER UND VERFAHREN ZUM SCHUTZ EINES LEISTUNGSHALBLEITERS VOR ÜBERSPANNUNGEN**
OVERVOLTAGE PROTECTION CIRCUIT FOR A POWER SEMICONDUCTOR AND METHOD FOR PROTECTING A POWER SEMICONDUCTOR FROM OVERVOLTAGES
CIRCUIT DE PROTECTION CONTRE DES SURTENSIONS POUR UN SEMI-CONDUCTEUR DE PUISSANCE ET PROCÉDÉ DE PROTECTION D'UN SEMI-CONDUCTEUR DE PUISSANCE CONTRE DES SURTENSIONS

(30) Priorität: 29.10.2013 DE 102013221900
(43) Veröffentlichungstag der Anmeldung: 07.09.2016
(73) Patentinhaber: Robert Bosch GmbH, 70442 Stuttgart (DE)
(72) Erfinder: PURCAREA, Calin, 70599 Stuttgart (DE); FEUERSTACK, Peter, 71642 Ludwigsburg (DE)
(86) Internationale Anmeldenummer: PCT/EP2014/072487
(87) Internationale Veröffentlichungsnummer: WO 2015/062902

(56) Entgegenhaltungen:
- EP-A1- 0 206 505
- EP-A1- 0 757 443
- US-A- 4 359 652
- US-A- 6 087 877
- US-A1- 2003 042 939
- US-A1- 2005 179 463
- US-A1- 2012 236 456
- BONGSEONG KIM ET AL: "Active Clamping Circuit to Suppress Switching Stress on a MOS-Gate-Structure-Based Power Semiconductor for Pulsed-Power Applications", IEEE TRANSACTIONS ON PLASMA SCIENCE, IEEE SERVICE CENTER, PISCATAWAY, NJ, US, Bd. 39, Nr. 8, 1. August 2011 (2011-08-01) , Seiten 1736-1742, XP011370964, ISSN: 0093-3813, DOI: 10.1109/TPS.2011.2159136

## Beschreibung

Die vorliegende Erfindung betrifft eine Überspannungsschutzschaltung für einen Leistungshalbleiter und ein Verfahren zum Schutz eines Leistungshalbleiters vor Überspannungen.

Leistungsschalter auf Basis von Halbleiterschaltern sind bekannt. Da solche Leistungshalbleiterschalter keine beweglichen mechanischen Teile aufweisen, ermöglichen sie über einen langen Zeitraum hinweg einen verschleißfreien Betrieb bei sehr kurzen Schaltzeiten. Beispielsweise werden als solche Leistungshalbleiterschalter bipolare Transistoren mit einem isolierten Gate (IGBT) oder Metall-Oxid-Halbleiter-Feldeffekttransistoren (MOSFET) verwendet. Zum Schutz dieser Transistoren werden die Leistungshalbleiterschalter zusätzlich noch mit einer Freilaufdiode ausgestattet. Da die Spannungsfestigkeit solcher Leistungshalbleiterschalter begrenzt ist, muss mit zusätzlichen Schaltungsmaßnahmen sichergestellt werden, dass die Spannung zwischen Eingang und Ausgang des Leistungshalbleiterschalters stets geringer ist als eine sogenannte Durchschlagspannung. Steigt die Spannung zwischen den Anschlüssen des Leistungshalbleiterschalters über diese Durchschlagspannung, so besteht die Gefahr, dass der Leistungshalbleiterschalter zerstört wird. Diese Zerstörung ist irreversibel.

Um daher die Leistungshalbleiterschalter vor solchen gefährlichen Überspannungen zu schützen, werden sogenannter Zener-Dioden oder auch Suppressor-Dioden eingesetzt. Sollte zum Beispiel aufgrund eines unterbrochenen Stromflusses in einer Lastinduktivität eine Überspannungsspitze entstehen, so wird bei Überschreiten der Durchbruchspannung der Zener- oder Suppressor-Diode der entsprechende Leistungshalbleiterschalter aktiv angesteuert. Somit ist ein erneuter Stromfluss durch den Leistungshalbleiterschalter möglich, wodurch die Spannungsspitze auf einen sicheren Wert begrenzt wird. Zusätzlich befindet sich häufig ein Regler in dem Schaltkreis, der eine Spannung am Ausgang über einen Eingriff auf die Steuerspannung des Leistungshalbleiterschalters begrenzt. Ein solcher Regler besitzt jedoch eine geringe Dynamik, so dass hierdurch kurze Überspannungsspitzen nicht ausgeregelt werden, wodurch der Einsatz der zuvor beschriebenen Zener- oder Suppressor-Dioden erforderlich wird.

US 2003/0042939 A1 offenbart eine Treiberschaltung für einen IGBT. Die Treiberschaltung ist über kapazitive Bauelemente mit dem Ausgang des IGBT verbunden und dabei derart ausgelegt, dass während eines Schaltvorgangs das Auftreten von Überspannungen unterdrückt werden kann.

EP 0 206 505 A1 offenbart eine Überstromschutzschaltung für einen MOSFET. Dabei wird die Spannung zwischen Drain und Source des zu schützenden FET mittels einer Schutzschaltung überwacht.

Die Deutsche Patentanmeldung DE 10 2010 008 815 A1 offenbart eine Vorrichtung zum Schutz eines Halbleiters vor Überspannungen, wobei die Vorrichtung nur dann in einen aktiven Zustand versetzt wird, wenn der Halbleiterschalter abgeschaltet ist. Der Überspannungsschutz ist dabei durch Beschaltung mit Zener-Dioden realisiert.

Dem Schutz von Leistungshalbleiterschaltern kommt daher eine große Bedeutung zu. Daher besteht ein Bedarf nach einem sicheren Überspannungsschutz von Leistungshalbleitern. Insbesondere besteht ein Bedarf nach einem Überspannungsschutz für Leistungshalbleiter, der eine geringe Temperaturabhängigkeit aufweist. Darüber hinaus besteht auch ein Bedarf nach einem Überspannschutz von Leistungshalbleiterschaltern, der eine geringe Toleranz und ein hohe Alterungsbeständigkeit aufweist.

### Offenbarung der Erfindung

Die vorliegende Erfindung schafft hierzu eine Überspanungsschutzschaltung für einen Leistungshalbleiterschalter und ein Verfahren zum Schutz eines Leistungshalbleiters vor Überspannungen mit den Merkmalen der unabhängigen Patentansprüche.

### Vorteile der Erfindung

Der vorliegenden Erfindung liegt dabei die Idee zugrunde, die an dem Leistungshalbleiterschalter anliegende Spannung mittels eines Spannungsteilers zu erfassen und dabei ein zu der am Leistungshalbleiterschalter anliegenden Spannung proportionales, kleineres Spannungssignal auszuwerten. Die Auswertung des entsprechend kleineren Spannungssignals am Ausgang des Spannungsteilers wird dabei durch einen Überspannungsdetektor überwacht. Vorzugsweise handelt es sich bei dem Überspannungsdetektor um eine Halbleiterdiode, die bei Überschreiten einer vorbestimmten Spannung leitfähig wird. Aufgrund der durch den Spannungsteiler deutlich herabgesetzten zu überwachenden Spannung kann dabei für die Überwachung einer auftretenden Überspannung ein für diese niedere Spannung optimiertes Bauteil eingesetzt werden.

Während Leistungshalbleiterschalter je nach Anwendungsgebiet für Spannungen im Bereich von einigen hundert Volt eingesetzt werden, kann durch das Herabsetzen der Spannung mittels Spannungsteilers ein Überspannungsdetektor in einem deutlich geringeren Spannungsbereich verwendet werden. Solche Überspannungsdetektoren sind deutlich preiswerter zu erhalten. Darüber hinaus kann bei der Auswahl eines geeigneten Überspannungsdetektors auch auf Bauteile zurückgegriffen, die - unabhängig von der tatsächlich am Leistungshalbleiterschalter auftretenden Spannung - optimierte Betriebsparameter aufweisen. Beispielsweise kann ein Überspannungsdetektor ausgewählt werden, der einen besonders geringen Toleranzbereich aufweist. Hierdurch kann das Ansprechverhalten des Überspannungsschutzes verbessert werden.

Weiterhin kann als Überspannungsschutz auch ein Bauteil verwendet werden, das eine geringe Temperaturabhängigkeit aufweist. Da gerade beim Schalten von großen Leistungen auch hohe thermische Verluste in Form von Wärme entstehen, führen die damit verbundenen Temperaturschwankungen zu großen Abweichungen im Ansprechverhalten von konventionellen Schutzvorrichtungen. Durch eine optimierte Auswahl geeigneter Überspannungsschutzvorrichtungen kann diese Temperaturabhängigkeit verbessert werden.

Weiterhin kann aufgrund der angepassten Ansprechspannung des entsprechenden Überspannungsschutzes auch das Alterungsverhalten des Überspannungsschutzes verbessert werden. Aufgrund des reduzierten Spannungsbereiches können Überspannungsschutzkomponenten verwendet werden, die deutlich weniger altern. Dies führt dazu, dass bei der Dimensionierung der erfindungsgemäßen Überspannungsschutzvorrichtung deutlich geringere Sicherheitszuschläge erforderlich sind und somit auch das Ansprechverhalten besser auf die Durchbruchsspannung des verwendeten Leistungshalbleiterschalters angepasst werden kann.

In einer Ausführungsform der Überspannungsschutzschaltung ist der Überspannungsdetektor eine Zener-Diode, eine Suppressor-Diode oder eine Avalanche-Diode. Diese Bauelemente verhalten sich unterhalb einer vorgegebenen Spannung zunächst wie eine konventionelle Diode. Übersteigt die angelegte Spannung einer solchen Diode in Sperrrichtung eine vorbestimmte Grenzspannung, so wird eine solche Diode auch in Sperrrichtung leiten. Somit kann auf einfache Weise das Überschreiten einer vorgegebenen Grenzspannung detektiert werden.

In einer Ausführungsform ist die vorbestimmte Spannung, bei der der Überspannungsdetektor in einen zumindest teilweise elektrisch leitfähigen Zustand übergeht, kleiner als 10 Volt. Vorzugsweise liegt die vorbestimmte Spannung, bei der der Überspannungsdetektor in den leitfähigen Zustand übergeht, etwa im Bereich zwischen 5 und 6 Volt. Überspannungsdetektoren, insbesondere die zuvor genannten Zener- oder Suppressor-Dioden mit einer Ansprechspannung in diesem Bereich können besonders kostengünstig und mit sehr guten Eigenschaften hergestellt werden. Solche Überspannungsdetektoren weisen eine besonders geringe Toleranz der Ansprechspannung auf. Darüber hinaus besitzen Überspannungsdetektoren für diesen Spannungsbereich auch eine geringe Temperaturabhängigkeit.

In einer Ausführungsform ist der Halbleiterschalter ein MOSFET oder ein bipolarer Transistor. Solche Halbleiterschalter eignen sich besonders gut, um aus dem in der Überspannungsschutzschaltung generierten Signal bei der Detektion einer Überspannung ein Ausgangssignal bereitzustellen, das dazu geeignet ist, den Leistungshalbleiter bei Überschreiten einer zulässigen Spannung vor Überspannungen zu schützen. Insbesondere sind solche Transistoren sehr gut dazu geeignet, das bei einem relativ niederen Spannungsniveau generierte Signal zur Detektion einer Überspannung in ein Signal eines höheren Spannungsniveaus zu verstärken.

In einer Ausführungsform ist der Eingang des Halbleiterschalters mit dem ersten Anschlusspunkt der Überspannungsschutzschaltung verbunden. Vorzugsweise ist der Eingang des Halbleiterschalters dabei über eine Diode mit dem ersten Anschlusspunkt der Überspannungsschutzschaltung verbunden.

In einer alternativen Ausführungsform ist der Eingang des Halbleiterschalters mit einer Versorgungsspannung der Überspannungsschutzschaltung verbunden. Auf diese Weise kann eine besonders stabile Spannung zum Betrieb der Überspannungsschutzschaltung bereitgestellt werden.

In einem weiteren Aspekt schafft die vorliegende Erfindung eine Stromrichterschaltung mit einem Leistungshalbleiterschalter und einer erfindungsgemäßen Überspannungsschutzschaltung.

In einer Ausführungsform umfasst die Stromrichterschaltung eine Mehrzahl von kaskadierten Überspannungsschutzschaltungen.

### Kurze Beschreibung der Zeichnungen

Weitere Ausführungsformen und Vorteile der vorliegenden Erfindung ergeben sich aus der nachfolgenden Beschreibung mit Bezug auf die beigefügten Zeichnungen. Dabei zeigen:
- Figur 1:: eine schematische Darstellung eines Schaltbilds mit einer dreiphasigen Stromrichterschaltung;
- Figur 2:: eine schematische Darstellung eines Prinzipschaltbilds einer Stromrichterschaltung mit einer Überspannungsschutzschaltung gemäß einem ersten Ausführungsbeispiel;
- Figur 3:: eine schematische Darstellung eines Prinzipschaltbilds einer mit einer Überspannungsschutzschaltung gemäß einem weiteren Ausführungsbeispiel;
- Figur 4:: eine schematische Darstellung eines Prinzipschaltbilds einer Stromrichterschaltung mit einer Überspannungsschutzschaltung gemäß einem alternativen Ausführungsbeispiel;
- Figur 5:: eine schematische Darstellung eines Ausführungsbeispiels einer Stromrichterschaltung mit einer Überspannungsschutzschaltung gemäß noch einem weiteren Ausführungsbeispiel;
- Figur 6:: eine schematische Darstellung eines Prinzipschaltbilds einer Stromrichterschaltung mit einer Überspannungsschutzschaltung gemäß einem weiteren Ausführungsbeispiel;
- Figur 7:: eine schematische Darstellung eines Prinzipschaltbilds für eine Stromrichterschaltung mit einer Überspannungsschutzschaltung gemäß einem alternativen Ausführungsbeispiel;
- Figur 8:: eine schematische Darstellung eines Prinzipschaltbilds einer Stromrichterschaltung mit einer kaskadierten Überspannungsschutzschaltung gemäß einem weiteren Ausführungsbeispiel; und
- Figur 9:: eine schematische Darstellung eines Ablaufdiagramms für ein Verfahren wie es einem weiteren Ausführungsbeispiel der vorliegenden Erfindung zugrunde liegt.

### Beschreibung von Ausführungsbeispielen

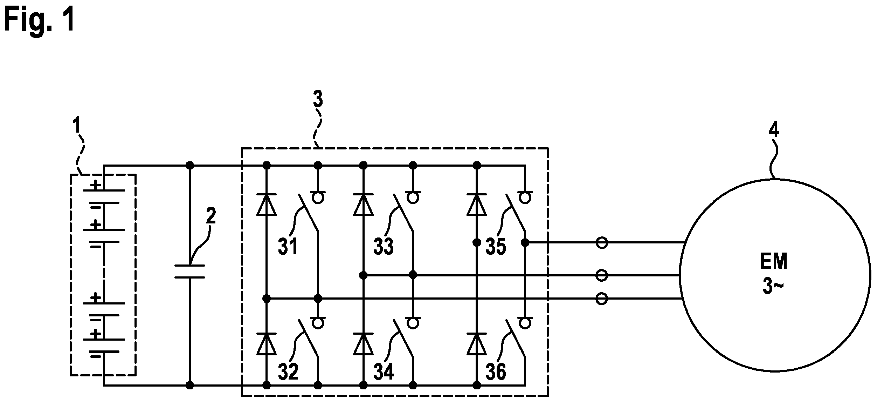

Figur 1 zeigt ein Prinzipschaltbild eines dreiphasigen Inverters für ein Antriebssystem. Von einem elektrischen Energiespeicher 1, beispielsweise einer Batterie, wird zunächst eine Gleichspannung bereitgestellt. Diese Gleichspannung wird von einem Zwischenkreiskondensator 2 gepuffert und anschließend einem Wechselrichter 3 (Inverter) zugeführt. Der Wechselrichter 3 formt dabei die bereitgestellte Gleichspannung so um, dass eine Wechselspannung entsteht, die dazu geeignet ist, einen elektrischen Antrieb 4 anzusteuern.

Der Wechselrichter 3 umfasst dabei in dem hier dargestellten Beispiel sechs Leistungshalbleiterschalter 31-36. Vorzugsweise handelt es sich bei den Halbleiterschaltern 31-36 jeweils um einen MOSFET oder einen IGBT. Zum Schutz der Leistungshalbleiterschalter 31-36 ist jedem dieser Bauelemente jeweils eine Freilaufdiode parallelgeschaltet. Die im Nachfolgenden näher beschriebene Überspannungsschutzschaltung für jeden der Leistungshalbleiterschalter 31-36 ist dabei der Übersicht halber in dieser Figur zunächst nicht dargestellt.

Obwohl die vorliegende Erfindung hier im Zusammenhang mit einer Treiberschaltung für die Ansteuerung eines dreiphasigen Antriebssystems beschrieben wird, das durch eine Gleichspannungsbatterie gespeist wird, ist die vorliegende Erfindung nicht auf diesen Anwendungsfall beschränkt. Vielmehr lässt sich die im Nachfolgenden näher beschriebene Überspannungsschutzschaltung für Leistungshalbleiterschalter in einem beliebigen Anwendungsbereich verwenden. Dabei können die einzelnen Leistungshalbleiterschalter, die durch eine solche Überspannungsschutzschaltung vor Überspannungen geschützt werden, wie bei der zuvor beschriebenen dreiphasigen Ansteuerschaltung zu Gruppen mit mehreren Leistungshalbleiterschaltern 31-36 ausgeführt werden. Alternativ lässt sich die erfindungsgemäße Überspannungsschutzschaltung hierdurch auch für Anwendung einsetzen, die nur einen einzigen Leistungshalbleiterschalter aufweisen.

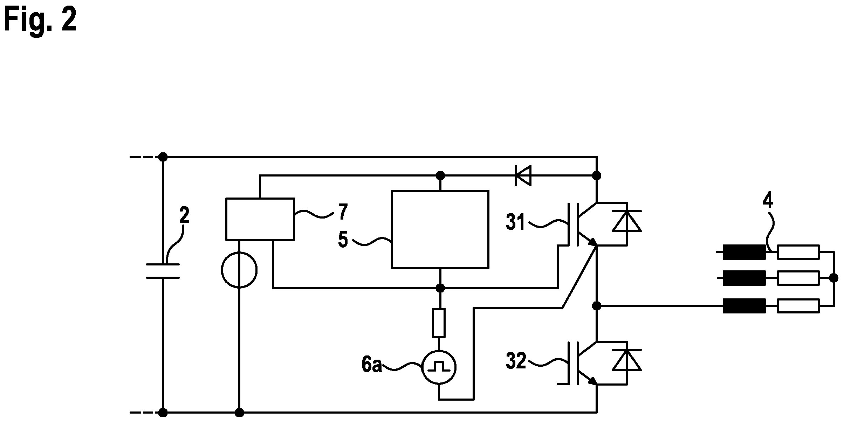

Figur 2 zeigt ein Prinzipschaltbild für eine Stromrichterschaltung mit einer Überspannungsschutzschaltung 5. Analog zu dem in Figur 1 dargestellten Prinzipschaltbild wird auch hier die Stromrichterschaltung von einer Batterie gespeist (hier nicht dargestellt). Zur Pufferung der bereitgestellten Gleichspannung ist am Eingang der Stromrichterschaltung ein Zwischenkreiskondensator 2 angeordnet. Mit den beiden Halbleiterschaltern 31 und 32 kann die Last 4 an die positive oder negative Seite des Zwischenkreiskondensators 2 geschaltet werden. Die beiden Leistungshalbleiterschalter 31 und 32 werden dabei im Gegentakt betrieben, wobei jedoch beim Umschalten eine gewisse Totzeit eingehalten wird, um Überschneidungen zu vermeiden, bei denen beide Leistungshalbleiterschalter 31 und 32 gleichzeitig leitend sind.

Die Ansteuerung des ersten Leistungshalbleiterschalters 31 erfolgt dabei mittels einer Ansteuerschaltung 6a. Durch diese Ansteuerschaltung 6a wird an dem Steuereingang des ersten Leistungshalbleiterschalters 31 ein Steuersignal angelegt, wodurch der erste Leistungshalbleiterschalter 31 geschlossen oder zumindest teilweise geöffnet werden kann.

Ist der erste Leistungshalbleiterschalter 31 geöffnet, so kann es aus verschiedenen Gründen zu einem Spannungsanstieg zwischen dem Eingang und dem Ausgang des Leistungshalbleiterschalters 31 kommen. Um eine Beschädigung des Leistungshalbleiterschalters 31 zu vermeiden, wird die Spannung zwischen Eingang und Ausgang des ersten Leistungshalbleiterschalters 31 durch die Überspannungsschutzschaltung 5 überwacht. Überschreitet die am Leistungshalbleiterschalter 31 anliegende Spannung dabei einen vorbestimmten Wert, so wird durch die Überspannungsschutzschaltung 5 der Leistungshalbleiterschalter 31 durch Ansteuern des Steuereingangs in einen zumindest teilweise elektrisch leitfähigen Zustand gebracht, so dass die Spannung zwischen Eingang und Ausgang des Leistungshalbleiterschalters 31 wieder sinkt. Die Funktion der Überspannungsschutzschaltung 5 wird nachfolgend noch detailliert beschrieben.

Zusätzlich weist die Stromrichterschaltung noch einen Regler 7 auf, der die Spannung durch Ansteuern des Steuereingangs des Leistungshalbleiterschalters 31 ebenfalls begrenzen kann. Dieser Regler weist jedoch eine relativ geringe Dynamik auf und ist daher nicht in der Lage, schnell auftretende Überspannungsspitzen unmittelbar zu kompensieren.

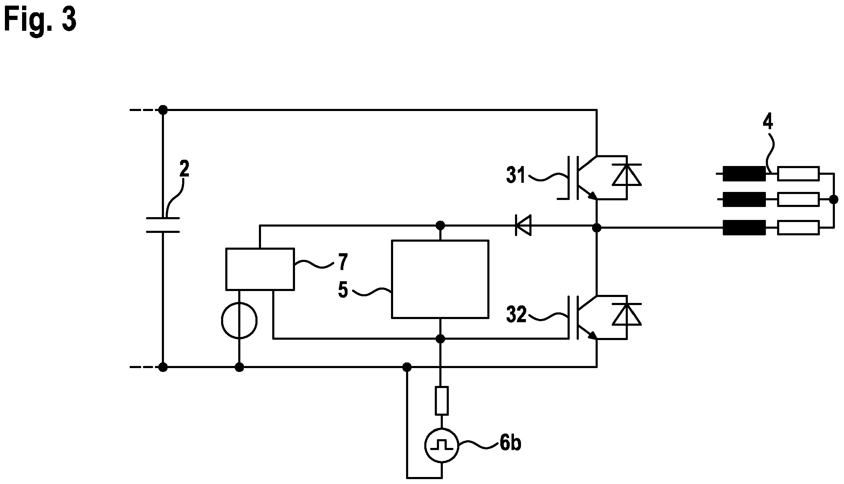

Figur 3 zeigt ein Prinzipschaltbild einer Stromrichterschaltung mit einer Überspannungsschutzschaltung 5 zum Schutz des zweiten Leistungshalbleiterschalters 32. Die Schaltungsanordnung ist dabei analog zu der Schaltungsanordnung aus Figur 2 aufgebaut. Normalerweise kann jeder Leistungshalbleiterschalter 31 und 32 durch eine entsprechende Überspannungsschutzschaltung 5 vor Überspannungspulsen geschützt werden. Die getrennte Darstellung der Überspannungsschutzschaltungen 5 für den ersten Leistungshalbleiterschalter 31 und den zweiten Leistungshalbleiterschalter 32 in den Figuren 2 und 3 dient dabei lediglich einer besseren Übersicht.

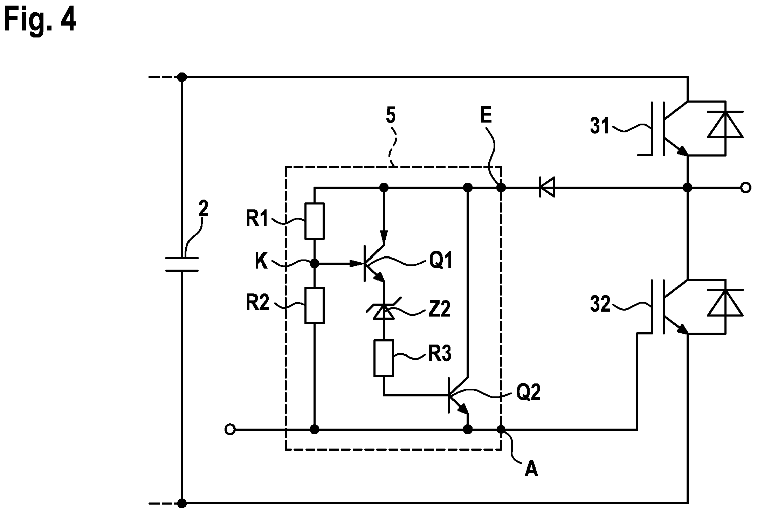

Figur 4 zeigt eine schematische Darstellung eines Prinzipschaltbilds für eine Stromrichterschaltung mit einer Überspannungsschutzschaltung 5 gemäß einer Ausführungsform. Die Überspannungsschutzschaltung 5 weist dabei einen ersten Anschlusspunkt E und einen zweiten Anschlusspunkt A auf. Der erste Anschlusspunkt E ist über eine Diode mit dem Ausgang der Stromrichterschaltung verbunden. Der zweite Anschlusspunkt A ist mit dem Steueranschluss des Leistungshalbleiterschalters 32 verbunden. Im Übrigen entspricht die Stromrichterschaltung den Stromrichterschaltungen aus den zuvor beschriebenen Figuren 2 und 3.

Die Überspannungsschutzschaltung 5 weist dabei einen Spannungsteiler aus den beiden Widerständen R1 und R2 auf. Ein erster Widerstand R1 ist dabei zwischen dem ersten Anschlusspunkt E und einem Knotenpunkt K angeordnet. Ein zweiter Widerstand ist zwischen dem zweiten Anschlusspunkt A der Überspannungsschutzschaltung 5 und dem Knotenpunkt K angeordnet. Während somit über dem Spannungsteiler aus den beiden Widerständen R1 und R2 die Spannung des Leistungshalbleiterschalters 32 abfällt, ist entsprechend dem Verhältnis der beiden Widerstände R1 und R2 an dem Knotenpunkt K nur ein Bruchteil dieser Spannung vorhanden. Somit wird durch den Spannungsteiler die Spannung zwischen dem Ausgang der Stromrichterschaltung und dem Steueranschluss des Leistungshalbleiterschalters 32 um den Faktor R1/(R1+R2) gesenkt. Die so reduzierte Spannung liegt an der Basis des Transistors Q1 an. Im leitenden Zustand verbindet somit dieser Transistor Q1 den ersten Anschlusspunkt E der Überspannungsschutzschaltung 5 mit einem Anschluss der Zener-Diode Z2. Der andere Anschluss dieser Zener-Diode Z2 ist über einen weiteren Widerstand R3 mit der Basis eines weiteren Transistors Q1 verbunden. Überschreitet die Spannung an dem Widerstand R2 die Durchbruchspannung der Zener-Diode Z2, dann fließt ein Strom in die Basis des Transistors Q1 und dieser Transistor wird leitend. Der Kollektorstrom dieses Transistors fließt nun über den Transistor Q1 und die Zener-Diode Z2 in die Basis des weiteren Transistors Q2. Somit wird auch der Transistor Q2 leitend. Damit fließt ein Strom in den Steueranschluss des Leistungshalbleiterschalters 32 und schaltet diesen Leistungshalbleiterschalter 32 zumindest teilweise ein. Hierdurch wird die Stromsteilheit in dem Leistungshalbleiterschalter 32 begrenzt und die Überspannung zwischen dem Eingang und dem Ausgang des Leistungshalbleiterschalters 32 wird reduziert.

Da durch den Spannungsteiler der beiden Widerstände R1 und R2 das Spannungspotential im Vergleich zu der Überspannung über dem Leistungshalbleiterschalter 32 deutlich vermindert wird, kann zur Detektion der Überspannung eine Zener-Diode Z2 oder eine entsprechende Suppressor-Diode mit einer verringerten Durchbruchspannung verwendet werden. Vorzugsweise liegt die Durchbruchspannung einer solchen Zener- oder Suppressor-Diode unter 10 Volt, besonders bevorzugt im Bereich zwischen 5 und 6 Volt. Solche Dioden sind einerseits besonders preiswert und darüber hinaus weisen sie auch bezüglich Ansprechspannung und Temperaturverhalten deutlich bessere Betriebsparameter auf, als dies bei Dioden der Fall ist, die eine wesentlich höhere Detektorspannung im Bereich von 100 oder mehreren hundert Volt aufweisen.

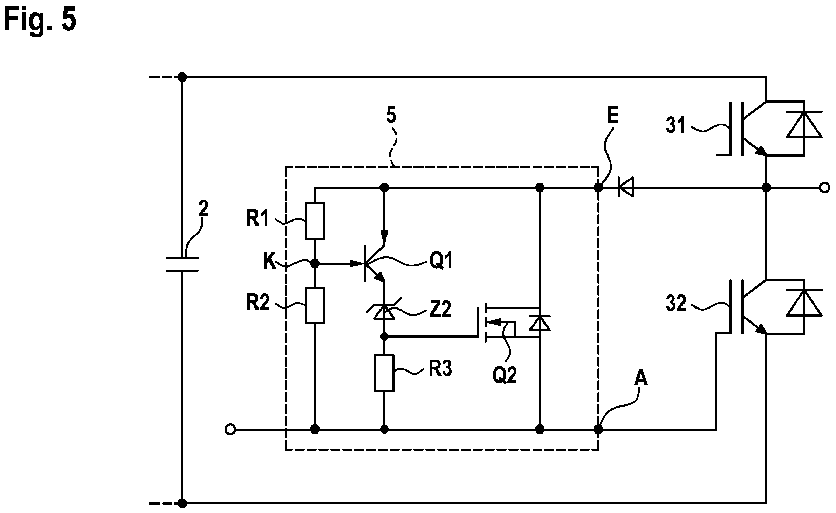

Figur 5 zeigt ein Prinzipschaltbild einer weiteren Ausführungsform einer Überspannungsschutzschaltung 5. Die Überspannungsschutzschaltung 5 entspricht dabei im Wesentlichen der Überspannungsschutzschaltung 5 der Figur 4. Lediglich der weitere Transistor Q2 ist in diesem Falle anstelle eines Bipolartransistors als MOSFET ausgeführt. Ferner ist der weitere Widerstand R3 in diesem Fall zwischen dem Steueranschluss des MOSFET Q2 und dem zweiten Anschlusspunkt A der Überspannungsschutzschaltung 5 angeordnet.

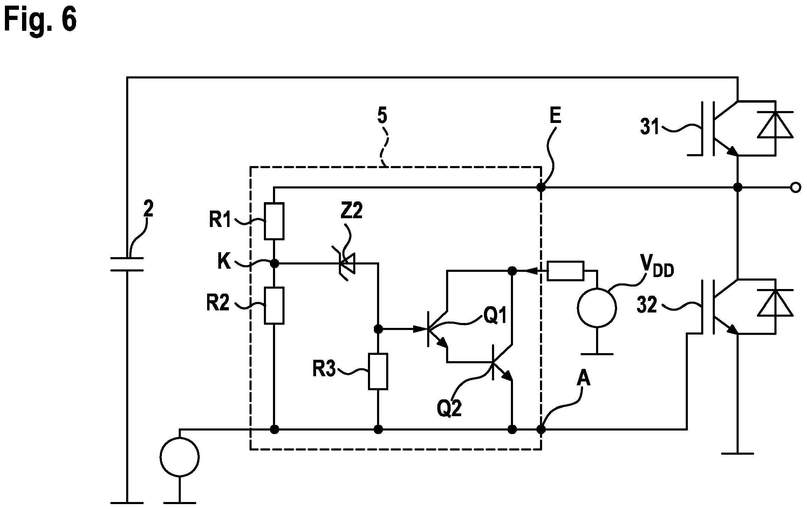

Figur 6 zeigt eine weitere alternative Ausführungsform einer Überspannungsschutzschaltung 5. Die Überspannungsschutzschaltung 5 weist in diesem Fall einen Bipolar-Darlington-Transistor-Schaltung aus den beiden Transistoren Q1 und Q2 auf. Die beiden Bipolartransistoren Q1 und Q2 werden dabei von einer Treiberversorgungsspannung V_{DD} gespeist. In diesem Fall müssen die beiden Bipolartransistoren Q1 und Q2 der Darlington-Schaltung nur eine Spannungsfestigkeit der Treiberversorgungsspannung V_{DD} aufweisen. Für diese Spannungsklasse sind Transistoren mit günstigen technischen Daten, wie zum Beispiel einer hohen Stromverstärkung, möglich. Der zwischen den Widerständen Q1 und Q2 und der Treiberspannung V_{DD} angeordnete Widerstand begrenzt dabei den maximalen Stromfluss in den Steueranschluss des Leistungshalbleiterschalters 32.

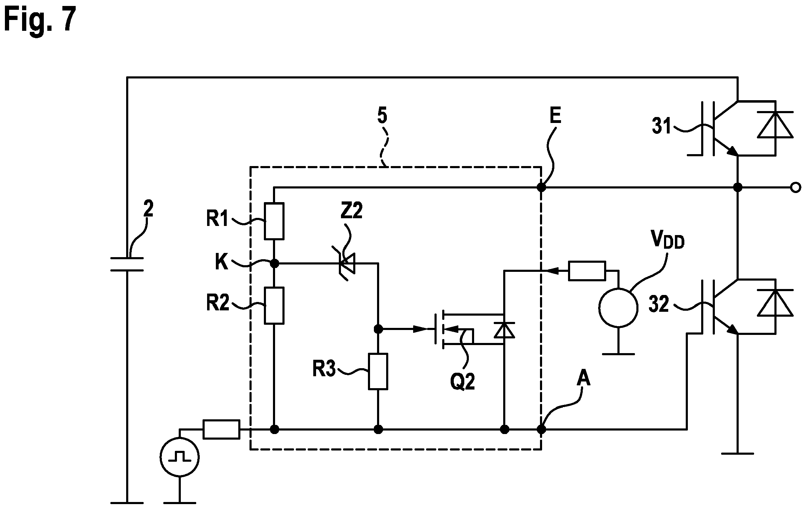

Figur 7 zeigt eine entsprechende MOSFET-Variante analog zu Figur 5, wobei in Figur 7 die Transistoren durch die Treiberversorgungsspannung V_{DD} analog zu Figur 6 gespeist werden.

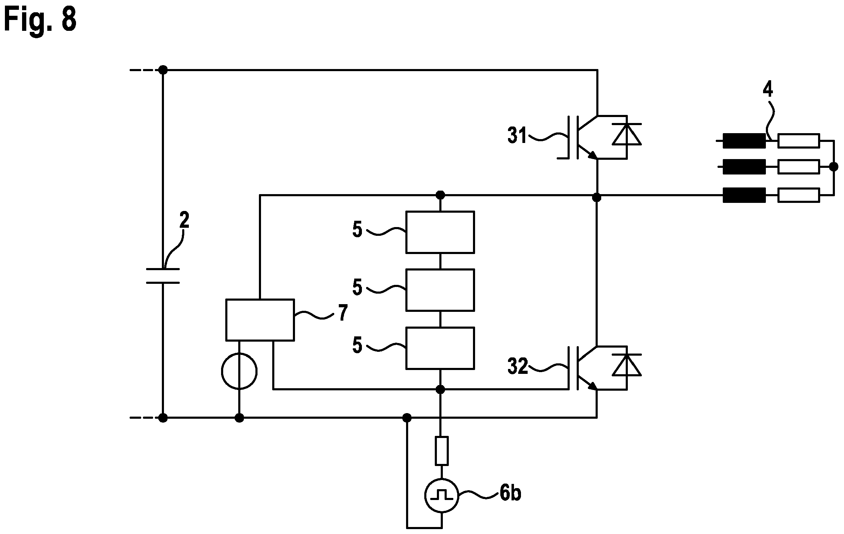

Figur 8 zeigt eine weitere Ausführungsform mit einer Mehrzahl von kaskadierten Überspannungsschutzschaltungen 5. Durch eine Kaskadierung mehrerer Überspannungsschutzschaltungen 5, bei denen der Ausgang einer Überspannungsschutzschaltung 5 mit einem Eingang einer nachfolgenden Überspannungsschutzschaltung 5 verbunden ist, kann die an den einzelnen Überspannungsschutzschaltungen 5 anliegende Spannung weiter gesenkt werden.

In allen zuvor beschriebenen Ausführungsbeispielen gibt die Überspannungsschutzschaltung 5 jeweils unmittelbar ein Steuersignal an den entsprechenden Leistungshalbleiterschalter 31, 32 ab, um diesen Leistungshalbleiterschalter 31, 32 in einen zumindest teilweise leitenden Zustand zu überführen. Alternativ ist es ebenso möglich, dass durch die Überspannungsschutzschaltung 5 zunächst ein Ausgangssignal an eine Treiberschaltung weitergegeben wird und die Treiberschaltung daraufhin veranlasst wird, den entsprechenden Leistungshalbleiterschalter 31, 32 derart anzusteuern, dass er in einen zumindest teilweise leitenden Zustand übergeht. Beispielsweise kann die Überspannungsschutzschaltung 5 hierzu an eine geeignete integrierte Schaltung ein entsprechendes Steuersignal ausgeben, das von der integrierten Schaltung ausgewertet wird, um den Leistungshalbleiterschalter 31, 32 anzusteuern. Alternativ zu einer integrierten Schaltung ist selbstverständlich auch eine diskret aufgebaute Ansteuerschaltung zur Ansteuerung der Leistungshalbleiterschalter 31, 32 möglich.

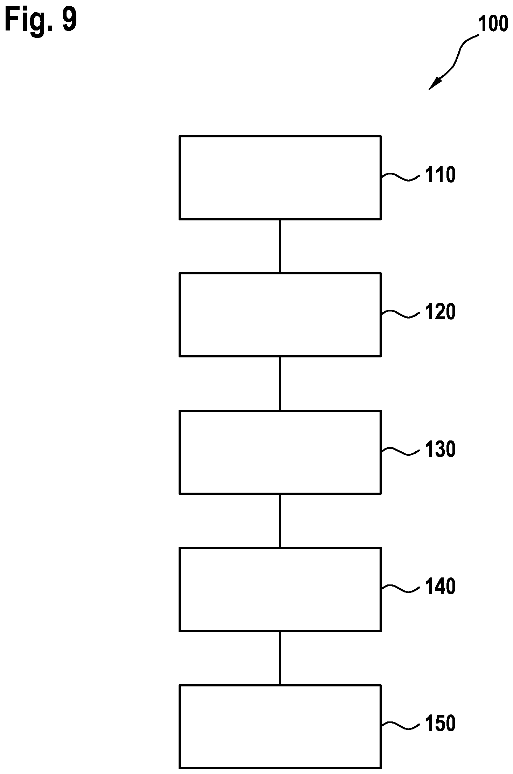

Figur 9 zeigt eine schematische Darstellung eines Ablaufdiagramms für ein Verfahren 100 zum Schutz eines Leistungshalbleiters 5 vor Überspannungen. In Schritt 110 wird ein Spannungsteiler mit einem ersten Widerstand R1 und einem zweiten Widerstand R2 bereitgestellt, wobei der erste Widerstand R1 und der zweite Widerstand R2 an einem Knotenpunkt K miteinander elektrisch verbunden sind. In Schritt 120 wird eine Spannung an einem Anschluss des Leistungshalbleiterschalters 31, 32 durch den Spannungsteiler erfasst. Weiterhin wird in Schritt 130 durch einen Überspannungsdetektor Z2 eine Spannung an dem Knotenpunkt K des Spannungsteilers überwacht. Wenn die von dem Überspannungsdetektor Z2 überwachte Spannung an dem Knotenpunkt K des Spannungsteilers eine vorbestimmte Spannung überschreitet, wird in Schritt 140 ein Halbleiterschalter Q2 angesteuert. Daraufhin wird in Schritt 150 ein Überspannungsschutzsignal ausgegeben. Durch dieses Überspannungsschutzsignal kann der zu überwachende Leistungshalbleiterschalter 31, 32 in einen zumindest teilweise leitenden Zustand überführt werden, wodurch die Überspannung an diesem Leistungshalbleiterschalter 31, 32 gesenkt wird.

Zusammenfassend betrifft die vorliegende Erfindung eine Überspannungsschutzschaltung und ein Verfahren zum Schutz eines Leistungshalbleiters vor Überspannungen. Hierzu wird eine über einem Leistungshalbleiterschalter anliegende Spannung zunächst mittels eines Widerstandsspannungsteilers auf ein zu der an dem Leistungshalbleiterschalter anliegenden Spannung korrespondierendes niederes Spannungssignal gewandelt. Daraufhin wird das reduzierte Spannungssignal durch einen Überspannungsdetektor, beispielsweise eine Zener- oder Suppressor-Diode ausgewertet und bei Überschreiten der Ansprechspannung dieser Diode der zu schützende Leistungshalbleiterschalter angesteuert. Durch das Absenken des Spannungsniveaus mittels Spannungsteiler kann zur Überwachung der Überspannung eine Zener- oder Suppressor-Diode mit einem niedrigeren Spannungsniveau verwendet werden, die gegenüber entsprechenden Dioden mit einem höheren Spannungsniveau verbesserte Betriebseigenschaften aufweist.

## Patentansprüche

1. Überspannungsschutzschaltung (5) für einen Leistungshalbleiterschalter (31, 32), mit:
einem ersten Widerstand (R1), der zwischen einem ersten Anschlusspunkt (E) der Überspannungsschutzschaltung (5) und einem Knotenpunkt (K) angeordnet ist;
einem zweiten Widerstand (R2);
einem Halbleiterschalter (Q2), mit einem Steueranschluss, einem Eingang und einem Ausgang, wobei der Ausgang mit einem zweiten Anschlusspunkt (A) der Überspannungsschutzschaltung (5) verbunden ist; und
einem Überspannungsdetektor (Z2), der dazu ausgelegt ist, bei Überschreiten einer vorbestimmten Spannung zwischen zwei Anschlüssen des Überspannungsdetektors (Z2) in einen zumindest teilweise elektrisch leitfähigen Zustand überzugehen, wobei der Überspannungsdetektor (Z2) in einem Strompfad zwischen dem Knotenpunkt (K) und dem Steueranschluss des Halbleiterschalters (Q2) angeordnet ist,
wobei der erste Anschlusspunkt (E) der Überspannungsschutzschaltung (5) mit einem Eingang des Leistungshalbleiterschalters (31, 32) verbunden ist und der zweite Anschlusspunkt (A) der Überspannungsschutzschaltung (5) mit einem Steueranschluss des Leistungshalbleiterschalters (31, 32) verbunden ist, und der zweite Widerstand (R2) zwischen dem Knotenpunkt (K) und dem zweiten Anschlusspunkt (A) der Überspannungsschutzschaltung (5) angeordnet ist.

2. Überspannungsschutzschaltung (5) nach Anspruch 1, wobei der Überspannungsdetektor (Z2) eine Zener-Diode, eine Suppressor-Diode oder eine Avalanche-Diode ist.

3. Überspannungsschutzschaltung (5) nach Anspruch 1 oder 2, wobei die vorbestimmte Spannung, bei der der Überspannungsdetektor (Z2) in einen zumindest teilweise elektrisch leitfähigen Zustand übergeht, kleiner als 10 Volt ist.

4. Überspannungsschutzschaltung (5) nach einem der Ansprüche 1 bis 3, wobei der Halbleiterschalter (Q2) ein MOSFET oder ein bipolarer Transistor ist.

5. Überspannungsschutzschaltung (5) nach einem der Ansprüche 1 bis 4, wobei der Eingang des Halbleiterschalters (Q2) mit dem erstem Anschlusspunkt (E) der Überspannungsschutzschaltung (5) verbunden ist.

6. Überspannungsschutzschaltung (5) nach einem der Ansprüche 1 bis 4, wobei der Eingang des Halbleiterschalters (Q2) mit einer Versorgungsspannung (V_{DD}) der Überspannungsschutzschaltung (5) verbunden ist.

7. Stromrichterschaltung, mit:
einem Leistungshalbleiterschalter (31, 32); und
einer Überspannungsschutzschaltung (5) nach einem der Ansprüche 1 bis 6.

8. Stromrichterschaltung nach Anspruch 7, wobei die Stromrichterschaltung eine Mehrzahl von kaskadierten Überspannungsschutzschaltungen (5) umfasst.

9. Verfahren (100) zum Schutz eines Leistungshalbleiters (31, 32) mit einem Steueranschluss vor Überspannungen, mit den Schritten:
Bereitstellen (110) eines Spannungsteilers mit einem ersten Widerstand (R1) und
einem zweiten Widerstand (R2), der mit dem ersten Widerstand (R1) an einem Knotenpunkt (K) elektrisch verbunden ist;
Erfassen (120) einer Spannung zwischen einem Eingangsanschluss und dem Steueranschluss des Leistungshalbleiterschalters (31, 32) durch den Spannungsteiler;
Überwachen (130) einer Spannung an dem Knotenpunkt (K) des Spannungsteilers durch einen Überspannungsdetektor (Z2);
Ansteuern (140) eines Halbleiterschalters (Q2), wenn die von dem Überspannungsdetektor (Z2) überwachte Spannung an dem Knotenpunkt (K) des Spannungsteilers eine vorbestimmte Spannung überschreitet; und
Ausgeben (150) eines Überspannungsschutz-Steuersignals an dem Steueranschluss des Leistungshalbleiterschalters (31, 32).

## Claims

1. Overvoltage protection circuit (5) for a power semiconductor switch (31, 32), comprising:
a first resistor (R1), which is arranged between a first connection point (E) of the overvoltage protection circuit (5) and a node (K);
a second resistor (R2);
a semiconductor switch (Q2), comprising a control connection, an input and an output, wherein the output is connected to a second connection point (A) of the overvoltage protection circuit (5); and
an overvoltage detector (Z2), which is designed to go into an at least partly electrically conductive state when a predetermined voltage between two connections of the overvoltage detector (Z2) is exceeded, wherein the overvoltage detector (Z2) is arranged in a current path between the node (K) and the control connection of the semiconductor switch (Q2),
wherein the first connection point (E) of the overvoltage protection circuit (5) is connected to an input of the power semiconductor switch (31, 32) and the second connection point (A) of the overvoltage protection circuit (5) is connected to a control connection of the power semiconductor switch (31, 32), and
the second resistor (R2) is arranged between the node (K) and the second connection point (A) of the overvoltage protection circuit (5).

2. Overvoltage protection circuit (5) according to Claim 1, wherein the overvoltage detector (Z2) is a Zener diode, a suppressor diode or an avalanche diode.

3. Overvoltage protection circuit (5) according to Claim 1 or 2, wherein the predetermined voltage at which the overvoltage detector (Z2) goes into an at least partly electrically conductive state is lower than 10 volts.

4. Overvoltage protection circuit (5) according to one of Claims 1 to 3, wherein the semiconductor switch (Q2) is a MOSFET or a bipolar transistor.

5. Overvoltage protection circuit (5) according to one of Claims 1 to 4, wherein the input of the semiconductor switch (Q2) is connected to the first connection point (E) of the overvoltage protection circuit (5).

6. Overvoltage protection circuit (5) according to one of Claims 1 to 4, wherein the input of the semiconductor switch (Q2) is connected to a supply voltage (V_{DD}) of the overvoltage protection circuit (5).

7. Converter circuit, comprising:
a power semiconductor switch (31, 32); and
an overvoltage protection circuit (5) according to one of Claims 1 to 6.

8. Converter circuit according to Claim 7, wherein the converter circuit comprises a plurality of cascaded overvoltage protection circuits (5).

9. Method (100) for protecting a power semiconductor (31, 32) comprising a control connection against overvoltages, comprising the steps of:
providing (110) a voltage divider comprising a first resistor (R1) and a second resistor (R2), said voltage divider being electrically connected to the first resistor (R1) at a node (K);
detecting (120) a voltage between an input connection and the control connection of the power semiconductor switch (31, 32) by way of the voltage divider;
monitoring (130) a voltage at the node (K) of the voltage divider by way of an overvoltage detector (Z2);
actuating (140) a semiconductor switch (Q2) when the voltage at the node (K) of the voltage divider that is monitored by the overvoltage detector (Z2) exceeds a predetermined voltage; and
outputting (150) an overvoltage protection control signal at the control connection of the power semiconductor switch (31, 32).

## Revendications

1. Circuit de protection contre les surtensions (5) destiné à un commutateur à semi-conducteur de puissance (31, 32), comprenant :
une première résistance (R1) disposée entre un premier point de connexion (E) du circuit de protection contre les surtensions (5) et un noeud (K) ;
une deuxième résistance (R2) ;
un commutateur à semi-conducteur (Q2), muni d'une borne de commande, d'une entrée et d'une sortie, dans lequel la sortie est connectée à une deuxième borne (A) du circuit de protection contre les surtensions (5) ; et
un détecteur de surtension (Z2) conçu pour passer dans un état au moins partiellement électriquement conducteur lorsqu'une tension prédéterminée entre deux bornes du détecteur de surtension (Z2) est dépassée, dans lequel le détecteur de surtension (Z2) est disposé sur un trajet de courant entre le noeud (K) et la borne de commande du commutateur à semi-conducteur (Q2),
dans lequel le premier point de connexion (E) du circuit de protection contre les surtensions (5) est connecté à une entrée du commutateur à semi-conducteur de puissance (31, 32) et le deuxième point de connexion (A) du circuit de protection contre les surtensions (5) est connecté à une borne de commande du commutateur à semi-conducteur de puissance (31, 32), et la deuxième résistance (R2) est disposée entre le noeud (K) et le deuxième point de connexion (A) du circuit de protection contre les surtensions (5).

2. Circuit de protection contre les surtensions (5) selon la revendication 1, dans lequel le détecteur de surtension (Z2) est une diode Zener, une diode de suppression ou une diode à avalanche.

3. Circuit de protection contre les surtensions (5) selon la revendication 1 ou 2, dans lequel la tension prédéterminée à laquelle le détecteur de surtension (Z2) passe dans un état au moins partiellement électriquement conducteur est inférieure à 10 volts.

4. Circuit de protection contre les surtensions (5) selon l'une quelconque des revendications 1 à 3, dans lequel le commutateur à semi-conducteur (Q2) est un transistor MOSFET ou un transistor bipolaire.

5. Circuit de protection contre les surtensions (5) selon l'une des revendications 1 à 4, dans lequel l'entrée du commutateur à semi-conducteur (Q2) est connectée au premier point de connexion (E) du circuit de protection contre les surtensions (5).

6. Circuit de protection contre les surtensions (5) selon l'une quelconque des revendications 1 à 4, dans lequel l'entrée du commutateur à semi-conducteur (Q2) est connectée à une tension d'alimentation (V_{DD}) du circuit de protection contre les surtensions (5).

7. Circuit convertisseur de courant, comprenant :
un commutateur à semi-conducteur de puissance (31, 32) ; et
un circuit de protection contré les surtensions (5) selon l'une quelconque des revendications 1 à 6.

8. Circuit convertisseur de courant selon la revendication 7, dans lequel le circuit convertisseur de courant comprend une pluralité de circuits de protection contre les surtensions (5) connectés en cascade.

9. Procédé (100) pour protéger un semi-conducteur de puissance (31, 32) comportant une borne de commande contre les surtensions, comprenant les étapes consistant à :
fournir (110) un diviseur de tension comportant une première résistance (R1) et une seconde résistance (R2) connectées électriquement à la première résistance (R1) au niveau d'un noeud (K) ;
détecter (120) une tension entre une borne d'entrée et la borne de commande du commutateur à semi-conducteur de puissance (31, 32) par l'intermédiaire du diviseur de tension ;
surveiller (130) une tension au niveau du noeud (K) du diviseur de tension au moyen d'un détecteur de surtension (Z2) ;
commander (140) un commutateur à semi-conducteur (Q2) lorsque la tension surveillée par ledit détecteur de surtension (Z2) dépasse une tension prédéterminée au niveau du noeud (K) du diviseur de tension ; et
délivrer (150) un signal de commande de protection contre les surtensions sur la borne de commande du commutateur à semi-conducteur de puissance (31, 32).
